# EUROPEAN PATENT SPECIFICATION

(11) **EP 2 669 693 B1**
(45) Date of publication and mention of the grant of the patent: **12.11.2014**
(21) Application number: 12854552.2
(22) Date of filing: 10.12.2012
(51) Int. Cl.: G01R 31/02, G01R 19/165, G01R 31/04

(54) **PARALLEL OPERATION WIRE FAULT DETECTION DEVICE AND SYSTEM**
VORRICHTUNG UND SYSTEM ZUR ERKENNUNG VON FEHLERN AUF EINEM PARALLELKABEL
DISPOSITIF ET SYSTÈME DE DÉTECTION DE DÉFAUT DE CÂBLE À FONCTIONNEMENT EN PARALLÈLE

(30) Priority: 02.03.2012 CN 201210054881
(43) Date of publication of application: 04.12.2013
(73) Proprietor: Huawei Technologies Co., Ltd., Shenzhen, Guangdong 518129 (CN)
(72) Inventor: LV, Yihang, Shenzhen, Guangdong 518129 (CN)
(74) Representative: Thun, Clemens
(86) International application number: PCT/CN2012/086261
(87) International publication number: WO 2013/127221

(56) References cited:
- EP-A2- 1 819 028
- CN-A- 101 111 773
- CN-A- 101 493 490
- CN-A- 101 769 976
- CN-A- 102 608 456
- CN-U- 202 004 426
- JP-A- 2011 089 849
- US-A1- 2004 178 801
- US-A1- 2008 150 539
- US-B1- 7 746 090

## Description

### TECHNICAL FIELD

The present invention relates to the field of electronic device technologies, and in particular, to an apparatus and a system for detecting faults on a parallel cable.

### BACKGROUND

In the fields of power supplies, electric devices and instruments such as a UPS (Uninterruptible Power Supply, uninterruptible power supply), multiple racks are usually combined to run in parallel. Parallel running of racks means that a parallel cable connector (male) on a rack is connected to a parallel cable connector (female) on another rack through a parallel cable so that data is exchanged between the racks and the running states of the racks are synchronized. During parallel running of the racks, each rack needs to detect faults on the connected parallel cable by using a parallel cable fault detection circuit, so as to ensure normal operation of the system.

The parallel cable fault detection circuit in the prior art generally works in the following way: One pin of a parallel cable connector on a rack is connect to the power supply, and one pin of a parallel cable connector on another rack connected to the rack is connect to the ground, a resistor is connected in series to the pin pulled up to connect to the power supply or the pin pulled down to connect to the ground, and each of the two pins is connected to a fault detection chip on the rack corresponding to this pin. When the parallel cable between two racks is connected and the racks run in parallel normally, the two racks use their respective pins as fault detection points to detect faults. In this case, the two racks detect a high level or a low level simultaneously; if a malfunction occurred in the parallel cable when the racks are running, the level state detected by one of the racks may change, and this rack may raise an alarm. Specifically, if a resistor is connected in series to the pin pulled up to connect to the power supply, when two racks run normally in parallel, the two racks detect a low level simultaneously; and, when the parallel cable is faulty, the level detected by one of the racks changes from the low level to a high level, and this rack raises an alarm. If a resistor is connected in series to the pin pulled down to connect to the ground, when two racks run normally in parallel, the two racks detect a high level simultaneously; and, when the parallel cable is faulty, the level detected by one of the racks changes from the high level to a low level, and this rack raises an alarm.

US patent 7,746,090 discloses a system for testing connections of two connectors, each connector includes a pair of verification pins and a number of signal pins, the system include a verification testing module, a controlling module, a signal testing module, and a reporting module. The verification testing module is configured for detecting whether each pair of verification pins are electrically connected. The controlling module is configured for allowing communication between each pair of signal pins if the pair of verification pins is detected to be electrically connected. The signal testing module is configured for testing whether each pair of signal pins are electrically connected. The reporting module is configured for reporting the results of the verification testing module and the signal testing module. The signal testing module comprising: a first control unit configured to sequentially pull each of the signal pins of one connector down to ground; a second control unit configured to electrically pull a signal pin of the other connector corresponding to the signal pin which is pulled down to ground up to a high voltage level; a detecting unit configured for detecting the voltage level of the signal pins which is pulled down.In the process of implementing the present invention, it is found that the prior art has at least the following problems:

Multiple parallel cable connectors are generally set on one rack, and the rack can run in parallel with multiple racks through multiple parallel cables. When a rack is running in parallel with multiple racks, if a parallel cable between this rack and another rack is faulty and this rack raises an alarm, the operator is unable to locate the faulty parallel cable quickly and accurately, which affects the running of the entire system.

### SUMMARY

The embodiments of the present invention provide an apparatus and a system for detecting faults on a parallel cable to solve the problem that the prior art is unable to locate a faulty parallel cable quickly and accurately because only one rack raises an alarm when a parallel cable between two racks is faulty during parallel running of multiple racks.
In one aspect, an embodiment of the present invention provides an apparatus for detecting faults on a parallel cable, where one end of the parallel cable is connected to a first connector of a first rack, the other end of the parallel cable is connected to a second connector of a second rack, the first connector includes multiple first pins, and the second connector includes multiple second pins. The apparatus includes a first detecting module, a second detecting module, and a control module, where the first detecting module includes a first resistor, a first voltage change detection circuit, and a first switch circuit, the first resistor is connected in series between one of the first pins and a power supply, the first voltage change detection circuit is configured to output a first switch control signal according to voltage change of the first pin, an input end of the first voltage change detection circuit is connected to the first pin, an output end of the first voltage change detection circuit is connected to an input end of the first switch circuit, a first fault detection point is set on an output end of the first switch circuit, and the first switch circuit is configured to control the level state of the first fault detection point according to the first switch control signal output by the first voltage change detection circuit;

The second detecting module includes a second resistor and a second fault detection point, the second resistor is connected in series between one of the second pins and the ground, and the second fault detection point is set between the second pin and a non-grounded end of the second resistor; and

The control module is configured to send out an alarm signal when the level state of the first fault detection point and the level state of the second fault detection point change.

In another aspect, an embodiment of the present invention provides a system for detecting faults on a parallel cable, where the system includes a first rack, a second rack, a parallel cable, and the above apparatus for detecting faults on a parallel cable, the parallel cable is used to transmit data between the first rack and the second rack, one end of the parallel cable is connected to a first connector of the first rack, the other end of the parallel cable is connected to a second connector of the second rack, the first connector includes multiple first pins, and the second connector includes multiple second pins.

In the technical solutions disclosed in the embodiments of the present invention, the level state of a first fault detection point and the level state of a second fault detection point are controlled according to voltage change of a first pin and a second pin; therefore, when a parallel cable is faulty, both the level state of the first fault detection point and the level state of the second fault detection point change, and it can be quickly detected that the parallel cable between the two fault detection points is faulty; the problem in the prior art that only one rack raises an alarm and the faulty parallel cable cannot be located quickly is solved; and an operator can rectify the fault quickly and recover normal running of the system of combined racks in time.

### BRIEF DESCRIPTION OF DRAWINGS

To describe the technical solutions in the embodiments of the present invention more clearly, the following briefly introduces the accompanying drawings required for describing the embodiments of the present invention. Apparently, the accompanying drawings in the following description show merely some embodiments of the present invention, and persons of ordinary skill in the art may still derive other drawings from these accompanying drawings without creative efforts.
FIG. 1 is a schematic diagram of a parallel cable fault detection circuit in the prior art;
FIG. 2 is a structural block diagram of an apparatus for detecting faults on a parallel cable according to Embodiment 1 of the present invention;
FIG. 3 is a detailed circuit diagram of an apparatus for detecting faults on a parallel cable according to Embodiment 2 of the present invention;
FIG. 4 is a detailed circuit diagram of an apparatus for detecting faults on a parallel cable according to Embodiment 3 of the present invention;
FIG. 5 is a detailed circuit diagram of an apparatus for detecting faults on a parallel cable according to Embodiment 4 of the present invention; and

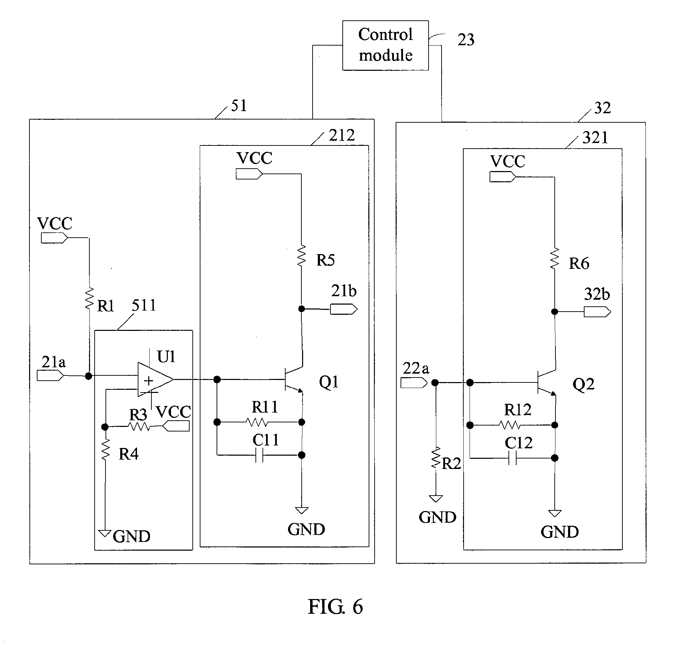

FIG. 6 is a detailed circuit diagram of an apparatus for detecting faults on a parallel cable according to Embodiment 5 of the present invention.

### DESCRIPTION OF EMBODIMENTS

To make the objectives, technical solutions, and advantages of the present invention more comprehensible, the following further describes the embodiments of the present invention in detail with reference to the accompanying drawings.

To facilitate description of the embodiments of the present invention, the following outlines the process and principles of parallel running of racks. Generally, a rack provides at least two connectors for parallel cables, and the connectors generally include a male connector and a female connector. When racks need to run in parallel, one end of the parallel cable is inserted into a male connector of a rack, and the other end is inserted into a female connector of another rack, to connect the two racks, so that data can be exchanged between the two racks. To ensure normal running of a system, a rack generally has a fault detection chip for detecting the level state of a fault detection point and determining whether the parallel cable is faulty according to change of the level state of the fault detection point. Specifically, the racks may be devices that need to interact with each other through interconnection, for example, a UPS, a frequency converter, or a telecom cabinet.

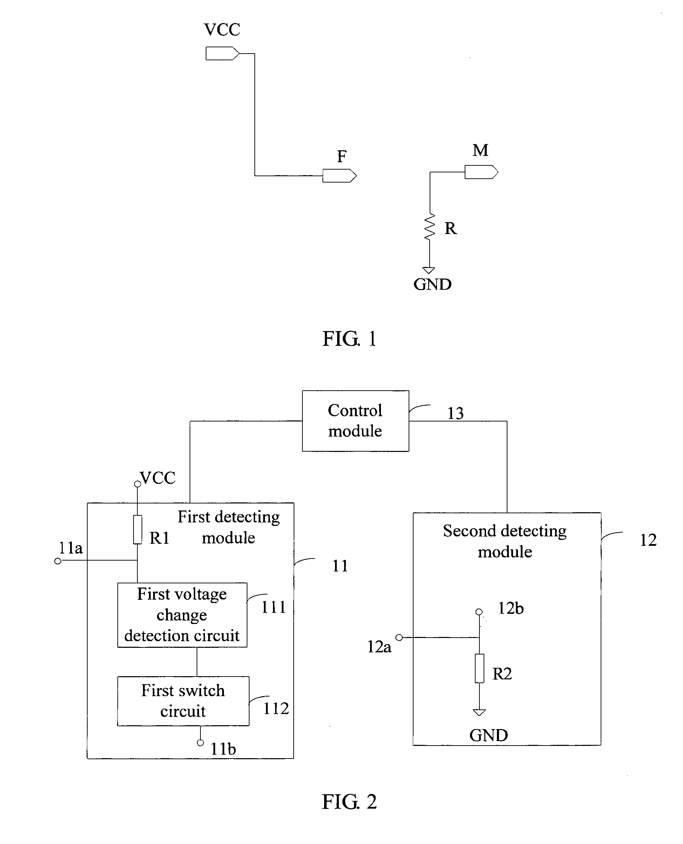

Specifically, FIG. 1 shows a parallel cable fault detection circuit in the prior art. As shown in FIG. 1, one of the pins of a connector for connecting to the parallel cable is pulled up to connect to a power supply VCC; on the other corresponding rack, one of the pins of a connector is pulled down through a resistor R to connect to the ground GND. When the parallel cable is disconnected, the corresponding pin of one rack is at a high level, and the corresponding pin of the other rack is at a low level. When the parallel cable is connected, that is, when F is connected to M in FIG. 1, the corresponding pins of both racks are at a high level. When the parallel cable is faulty, only the state of the rack corresponding to a pin which is at a low level changes, and the state of the rack corresponding to a pin which is at a high level does not change, that is, the level state at point M in FIG. 1 changes from a high level to a low level, but the level state at point F is always at a high level. Therefore, the fault detection chip on only one rack raises an alarm, which makes it hard to locate the faulty parallel cable accurately.

In all embodiments of the present invention, the first rack and the second rack refer to two racks connected through a parallel cable, where one end of the parallel cable is connected to a first connector of the first rack, and the other end of the parallel cable is connected to a second connector of the second rack. The first connector is male, and the second connector is female; the first connector includes multiple first pins, and the second connector includes multiple second pins.

### Embodiment 1

As shown in FIG. 2, the embodiment of the present invention provides an apparatus for detecting faults on a parallel cable. The apparatus includes a first detecting module 11, a second detecting module 12, and a control module 13. Specifically, the first detecting module 11 is connected to a first pin of the first connector, and the second detecting module 12 is connected to a second pin of the second connector. In FIG. 1, point 11a represents a connection point of the first detecting module 11 and the first pin, and point 12a represents a connection point of the second detecting module 12 and the second pin.

The first detecting module 11 includes a first resistor R1, a first voltage change detection circuit 111, and a first switch circuit 112. The first resistor R1 is connected in series between the first pin and the power supply VCC. The first voltage change detection circuit 111 is configured to output a first switch control signal according to voltage change of the first pin (that is, voltage change of point 11a). An input end of the first voltage change detection circuit 111 is connected to the first pin, and an output end of the first voltage change detection circuit 111 is connected to an input end of the first switch circuit 112. A first fault detection point 11b is set on an output end of the first switch circuit 112, and the first switch circuit 112 is configured to control the level state of the first fault detection point 11b according to the first switch control signal output by the first voltage change detection circuit 111. The second detecting module 12 includes a second resistor R2 and a second fault detection point, the second resistor R2 is connected in series between a second pin and the ground GND, and the second fault detection point 12b is set on the output end of the second detecting module 12. The control module 13 is configured to send out an alarm signal when the level state of the first fault detection point 11b and the level state of the second fault detection point 12b change. Specifically, as shown in FIG. 1, in the embodiment, the second fault detection point 12b may be set between the second pin and a non-grounded end of the second resistor R2.

Specifically, the first voltage change detection circuit 111 outputs a first switch control signal according to voltage change of the first pin, that is, by comparing the voltage value of the first pin with a voltage threshold, where the voltage threshold depends on features of components of the first voltage change detecting unit, which may be detailed later. When the voltage value of the first pin changes from below the voltage threshold to above the voltage threshold or changes from above the voltage threshold to below the voltage threshold, that is, when the voltage value of the first pin changes, the first voltage change detection circuit 111 outputs a first switch control signal such as a high level signal or a low level signal, so as to control the switching on/off of the first switch circuit 112 to change the level state of the first fault detection point 11b.

Further, the first circuit change detection circuit may be a zener diode, a comparator, or the like; and the first switch circuit may be a triode, a relay, a switch chip, or the like. Specifically, in an application instance of the embodiment of the present invention, the control module 13 may be an existing fault detection chip on a rack, which is easy to implement and cost-efficient.

In another application instance of the embodiment of the present invention, the control module 13 may be a stand-alone device such as a computer, and therefore, when multiple racks run in parallel, one host device may monitor all parallel cables simultaneously, which features easy control and high efficiency.

The following expounds the working principles of an apparatus for detecting faults on a parallel cable according to an embodiment of the present invention.

When a parallel cable connects a first connector to a second connector and works normally, point 11a is connected to point 12a, the voltage of point 11a changes from V0 to V, and the voltage of point 12a changes from 0V to V, where V = (r2/r1 + r2)*V0, V0 is a voltage value of a power supply VCC, r1 is a resistance value of a first resistor R1, and r2 is a resistance value of a second resistor R2. At this time, a first voltage change detecting unit 111 determines that the voltage value of point 11a is lower than a voltage threshold, and controls a first switch circuit 112 to switch off, the level state of the first fault detection point 11b is at a high level 1, and the level state of the second fault detection point 12b is also at the high level 1.

When the parallel cable is faulty, point 11a is disconnected from point 12a, the voltage of point 11a changes to V0, and the voltage of point 12a changes to 0V At this time, the first voltage change detecting unit 111 determines that the voltage value of point 11 a is higher than the voltage threshold, and controls the first switch circuit 112 to switch on, the level state of the first fault detection point 11b changes to a low level 0, and, at the same time, the level state of the second fault detection point 12b also changes to a low level 0. At this time, the control module 13 detects that both the level state of the first fault detection point 11b and the level state of the second fault detection point 12b change, and an alarm signal is sent.

Preferably, the second detecting module may further include a second switch circuit (not illustrated in the figure), an input end of the second switch circuit is connected to a second pin, and a second fault detection point is set on an output end of the second switch circuit. The working principles of the second switch circuit are the same as those of the first switch circuit, and are not described here any further.

Optionally, the second detecting module may further include a second voltage change detection circuit for determining voltage change of a second pin, where an input end of the second voltage change detection circuit is connected to the second pin, and an output end of the second voltage change detection circuit is connected to an input end of the second switch circuit. The working principles of the second voltage change detection circuit are the same as those of the first voltage change detection circuit, and are not described here any further.

It should be noted that in the embodiment of the present invention, there may be the same power supply or multiple power supplies, with their voltage values generally being 12V, which, however, shall not be construed as a limitation.

In the embodiment of the present invention, a first detecting module is connected to a connector of a first rack, and a second detecting module is connected to a corresponding connector of a second rack, where the first rack is connected to the second rack through a parallel cable; a first resistor in the first detecting module is connected in series between the first pin and a power supply, and a second resistor in the second detecting module is connected in series between the second pin and the ground, and therefore, when the parallel cable is faulty, both the voltage of the first pin and the voltage of the second pin change. Afterward, the first detecting module controls change of the level state of the first fault detection point according to the voltage change of the first pin, and the second detecting module controls change of the level state of the second fault detection point according to the voltage change of the second pin. In this way, when a parallel cable is faulty, both the level state of the first fault detection point and the level state of the second fault detection point change, and it can be quickly detected that the parallel cable between the two fault detection points is faulty; the problem in the prior art that only one rack raises an alarm and the faulty parallel cable cannot be located quickly is solved; and an operator can rectify a fault quickly and recover normal running of the system of combined racks in time. Moreover, because both fault detection points can detect the fault, false alarms that exist when only a single rack raises alarms are prevented.

### Embodiment 2

This embodiment expounds an apparatus for detecting faults on a parallel cable, taking a first voltage detection circuit of a zener diode as an example. As shown in FIG. 2, the embodiment provides an apparatus for detecting faults on a parallel cable. The apparatus includes a first detecting module 21, a second detecting module 22, and a control module 23. In FIG. 2, point 21a represents a connection point of the first detecting module 21 and a first pin, and point 22a represents a connection point of the second detecting module 22 and a second pin.

The first detecting module 21 includes a first resistor R1, a first voltage change detection circuit 211, and a first switch circuit 212. The first resistor R1 is connected in series between the first pin and a power supply VCC. The first voltage change detection circuit 211 is configured to output a first switch control signal according to voltage change of the first pin (that is, voltage change of point 21a). An input end of the first voltage change detection circuit 211 is connected to the first pin, and an output end of the first voltage change detection circuit 211 is connected to an input end of the first switch circuit 212. A first fault detection point 21b is set on an output end of the first switch circuit 212, and the first switch circuit 212 is configured to control the level state of the first fault detection point 21b according to the first switch control signal output by the first voltage change detection circuit 211.

The second detecting module 22 includes a second resistor R2 connected in series between the second pin and the ground GND, and a second fault detection point 22b is set on the output end of the second detecting module 22. In the embodiment, the second fault detection point 22b may be led out of the second pin directly.

The control module 23 is configured to send out an alarm signal when the level state of the first fault detection point 21b and the level state of the second fault detection point 22b changes.

Further, the first voltage change detection circuit 211 includes a first zener diode DZ1, a cathode of the first zener diode DZ1 is connected to the first pin (through point 21a), and an anode of the first zener diode DZ1 is connected to the input end of the first switch circuit 212. Further, the first switch circuit 212 includes a first triode Q1. A base electrode of the first triode Q1 is connected to an output end of the first voltage change detection circuit 211, that is, it is connected to the anode of the first zener diode DZ1, an collector of the first triode Q1 is connected to the power supply VCC through a fifth resistor R5, an emitter of the first triode Q1 is connected to the ground GND, and the first fault detection point 21b is set on the collector of the first triode Q1.

Preferably, a protection circuit is generally connected in series between the base electrode and the emitter of the first triode Q1, where the protection circuit is formed by a protection resistor R11 and a protection capacitor C11 that are connected in parallel.

The following expounds the working principles of an apparatus for detecting faults on a parallel cable according to an embodiment of the present invention.

When a parallel cable connects a first connector to a second connector and works normally, point 21a is connected to point 22a, the voltage of point 21a changes from V0 to V, and the voltage of point 12a changes from 0V to V, where V = (r2/r1 + r2)*V0, V0 is a voltage value of a power supply VCC, r1 is a resistance value of a first resistor R1, and r2 is a resistance value of a second resistor R2. At this time, a first voltage change detecting unit 211 determines that the voltage value of point 21a is lower than a voltage threshold, that is, the first zener diode DZ1 is in a cutoff state, and the first switch control signal output is of a low level, so as to control a first switch circuit 212 to switch off, that is, a collector and an emitter of the first triode Q1 are cut off, the level state of the first fault detection point 21b is at a high level 1, and the level state of the second fault detection point 22b is also at the high level 1.

When the parallel cable is faulty, point 21a is disconnected from point 22a, the voltage of point 21a changes to V0, and the voltage of point 22a changes to 0V At this time, the first voltage change detecting unit 111 determines that the voltage value of point 21a is higher than the voltage threshold, that is, the first zener diode DZ1 is in a reverse conduction state, and the first switch control signal output is at a high level, so as to control the first switch circuit 212 to switch on, that is, the collector of the first triode Q1 is connected to the emitter of the first triode Q1, the level state of the first fault detection point 21b changes to a low level 0, and, at the same time, the level state of the second fault detection point 22b also changes to the low level 0. At this time, the control module 23 detects that both the level state of the first fault detection point 21b and the level state of the second fault detection point 22b change, and an alarm signal is sent.

In this embodiment, a reverse breakdown voltage of the first zener diode DZ1 is the voltage threshold of the first voltage change detection circuit 211. When a parallel cable connects a first connector to a second connector and works normally, the voltage value V of the first pin is smaller than the reverse breakdown voltage of the first zener diode DZ1, and the voltage value V0 of the power supply VCC is greater than the reverse breakdown voltage of the first zener diode DZ1.

In an application instance of the embodiment, the power supply VCC may be 12 V, the resistance value r1 of the first resistor R1 may be equal to the resistance value r2 of the second resistor R2, taking 10 kΩ as an example; and the reverse breakdown voltage of the first zener diode DZ1 may be about 9 V. The resistance value r1 of the first resistor R1 may not be equal to the resistance value r2 of the second resistor R2, which may be set as required.

In the embodiment of the present invention, a first detecting module is connected to a connector of a first rack, and a second detecting module is connected to a corresponding connector of a second rack, where the first rack is connected to the second rack through a parallel cable; a first resistor in the first detecting module is connected in series between the first pin and a power supply, and a second resistor in the second detecting module is connected in series between the second pin and the ground, and therefore, when the parallel cable is faulty, both the voltage of the first pin and the voltage of the second pin change. Afterward, the first detecting module controls change of the level state of the first fault detection point according to the voltage change of the first pin, and the second detecting module controls change of the level state of the second fault detection point according to the voltage change of the second pin. In this way, when a parallel cable is faulty, both the level state of the first fault detection point and the level state of the second fault detection point change, and it can be quickly detected that the parallel cable between the two fault detection points is faulty; the problem in the prior art that only one rack raises an alarm and the faulty parallel cable cannot be located quickly is solved; and an operator can rectify a fault quickly and recover normal running of the system of combined racks in time. Moreover, because both fault detection points can detect the fault, false alarms possibly arising from the alarm of a single rack are prevented. Besides, the apparatus has a simple structure and is easy to implement without involving much change of a rack structure, which leads to a low manufacturing cost.

### Embodiment 3

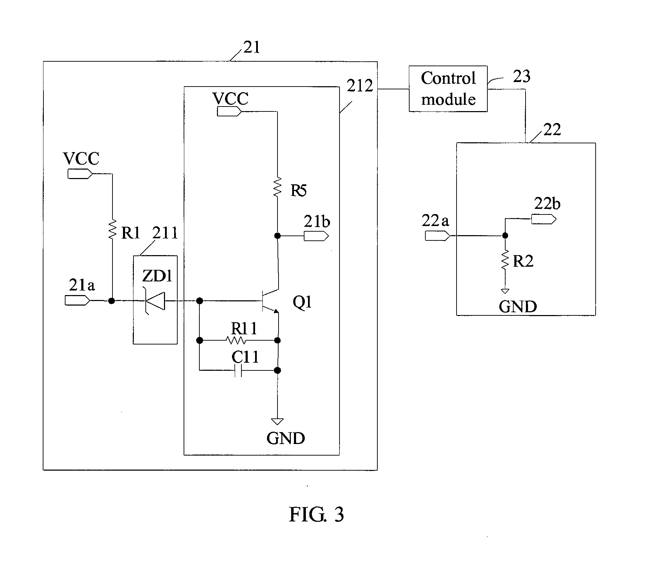

As shown in FIG. 3, this embodiment provides an apparatus for detecting faults on a parallel cable. Compared with the apparatus for detecting faults on a parallel cable in Embodiment 2, the apparatus in this embodiment has the same first detecting module 21 and the same control module 23, but has a second detecting module 32 different from the second detecting module 22 in Embodiment 2. Specifically, the difference lies in that: the second detecting module 32 in the apparatus in this embodiment further includes a second switch circuit 321, where an input end of the second switch circuit 321 is connected to a second pin, and a second fault detection point 32b is set on an output end of the second switch circuit 321. The second switch circuit 321 is configured to control the level state of the second fault detection point 32b according to voltage change of the second pin.

Specifically, the second switch circuit 321 includes a second triode Q2. A base electrode of the second triode Q2 is connected to the second pin (through point 22a), an collector of the second triode Q2 is connected to a power supply VCC through a sixth resistor R6, an emitter of the second triode Q2 is connected to the ground GND, and the second fault detection point 32b is set on the collector of the second triode Q2.

Preferably, a protection circuit is generally connected in series between the base electrode and the emitter of the first triode Q1, where the protection circuit is formed by a protection resistor R12 and a protection capacitor C12 that are connected in parallel.

The working principles of the second switch circuit 321 are the same as the working principles of the first switch circuit 212 in Embodiment 2.

In the embodiment of the present invention, a first detecting module is connected onto a connector of a first rack, and a second detecting module is connected onto a corresponding connector of a second rack, where the first rack is connected to the second rack through a parallel cable; a first resistor in the first detecting module is connected in series between the first pin and a power supply, and a second resistor in the second detecting module is connected in series between the second pin and the ground, and therefore, when the parallel cable is faulty, both the voltage of the first pin and the voltage of the second pin change. Afterward, the first detecting module controls change of the level state of the first fault detection point according to the voltage change of the first pin, and the second detecting module controls change of the level state of the second fault detection point according to the voltage change of the second pin. In this way, when a parallel cable is faulty, both the level state of the first fault detection point and the level state of the second fault detection point change, and it can be quickly detected that the parallel cable between the two fault detection points is faulty; the problem in the prior art that only one rack raises an alarm and the faulty parallel cable cannot be located quickly is solved; and an operator can rectify a fault quickly and recover normal running of the system of combined racks in time. Moreover, because both fault detection points can detect the fault, false alarms possibly arising from the alarm of a single rack are prevented.

### Embodiment 4

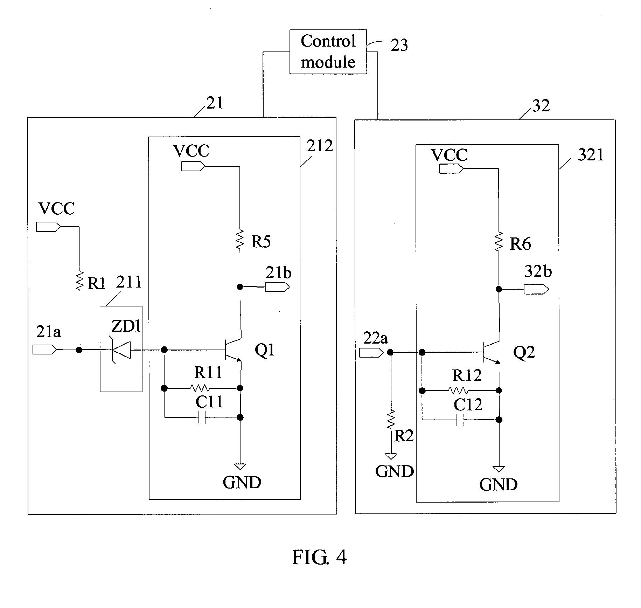

As shown in FIG. 4, this embodiment provides an apparatus for detecting faults on a parallel cable. The structure of the apparatus is basically the same as the structure of the apparatus for detecting faults on a parallel cable described in Embodiment 3. The difference lies in that the second detecting module 42 of the apparatus in Embodiment 4 further includes a second voltage change detection circuit 422 that is configured to output a second switch control signal according to voltage change of the second pin, where the second voltage change detection circuit 422 is connected between a second pin and an input end of the second switch circuit 321, and therefore, the second switch circuit 321 controls the level state of the second fault detection point according to the second switch control signal output by the second voltage change detection circuit 422.

Specifically, the second voltage change detection circuit 422 includes a second zener diode DZ2, a cathode of the second zener diode DZ2 is connected to the second pin (through point 22a), and an anode of the second zener diode DZ2 is connected to the input end of the second switch circuit 321, that is, connected to a base electrode of a second triode Q2.

When a parallel cable connects a first connector to a second connector and works normally, the voltage value of the second pin is greater than the reverse breakdown voltage of the second zener diode DZ2.

The working principles of the second voltage change detection circuit 422 are the same as the working principles of the first voltage change detection circuit 211 in Embodiment 2, and are not detailed here any further.

In an application instance of the embodiment, the power supply VCC may be 12 V, the resistance value r1 of the first resistor may be equal to the resistance value r2 of the second resistor, taking 10 kΩ as an example; the reverse breakdown voltage of the first zener diode DZ1 may be about 9 V, and the reverse breakdown voltage of the second zener diode DZ2 may be 4 V. The resistance value r1 of the first resistor R1 may be not equal to the resistance value r2 of the second resistor R2, which may be set as required.

In the embodiment of the present invention, a first detecting module is connected onto a connector of a first rack, and a second detecting module is connected onto a corresponding connector of a second rack, where the first rack is connected to the second rack through a parallel cable; a first resistor in the first detecting module is connected in series between the first pin and a power supply, and a second resistor in the second detecting module is connected in series between the second pin and the ground, and therefore, when the parallel cable is faulty, both the voltage of the first pin and the voltage of the second pin change. Afterward, the first detecting module controls change of the level state of the first fault detection point according to the voltage change of the first pin, and the second detecting module controls change of the level state of the second fault detection point according to the voltage change of the second pin. In this way, when a parallel cable is faulty, both the level state of the first fault detection point and the level state of the second fault detection point change, and it can be quickly detected that the parallel cable between the two fault detection points is faulty; the problem in the prior art that only one rack raises an alarm and the faulty parallel cable cannot be located quickly is solved; and an operator can rectify a fault quickly and recover normal running of the system of combined racks in time. Moreover, because both fault detection points can detect the fault, false alarms possibly arising from the alarm of a single rack are prevented.

### Embodiment 5

This embodiment expounds an apparatus for detecting faults on a parallel cable, taking a first voltage detection circuit of a comparator as an example.

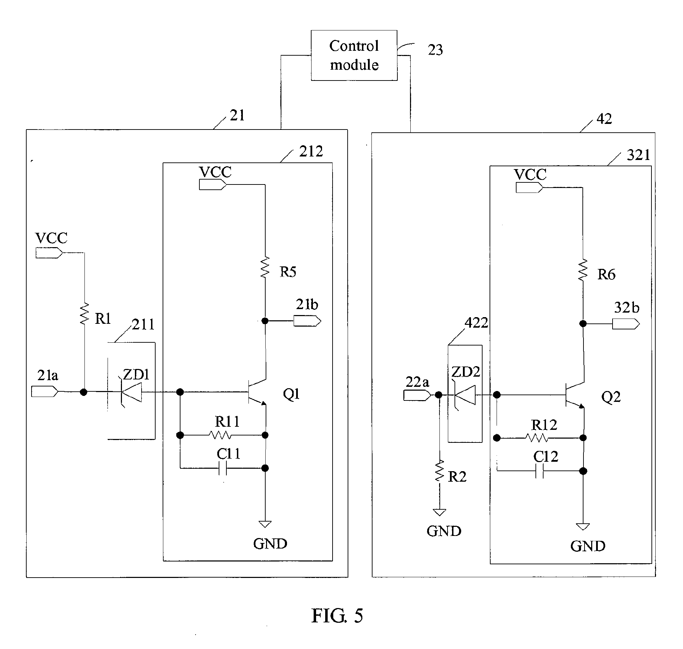

As shown in FIG. 5, this embodiment provides an apparatus for detecting faults on a parallel cable. The structure of the apparatus is basically the same as the structure of the apparatus for detecting faults on a parallel cable described in Embodiment 3. The only difference lies in that: the first voltage detection circuit 511 of the first detecting module 51 of the apparatus in Embodiment 5 includes a first comparator U1, where a non-inverting input end of the first comparator U1 is connected to the first pin (through point 21a), an inverting input end of the first comparator U1 is connected to one end of a third resistor R3 and one end of a fourth resistor R4, the other end of the third resistor R3 is connected to a power supply VCC, the other end of the fourth resistor R4 is connected to the ground GND, and an output end of the first comparator U1 is connected to the input end of the first switch circuit 212, that is, in this embodiment, connected to the base electrode of the first triode Q1.

In this embodiment, a reference voltage value of the inverting input end of the first comparator U1 is the voltage threshold of the first voltage change detection circuit 511. When a parallel cable connects a first connector to a second connector and works normally, the voltage value V of the first pin is less than the reference voltage value of the first comparator U1, the voltage value V0 of the power supply VCC is greater than the reference voltage value of the first comparator U1, and the first switch control signal output by the first voltage detection circuit 511 is at a high level.

It should be noted that the second detecting module in this embodiment may be the second detecting module described in Embodiment 2 or Embodiment 4, and the second detecting module in this embodiment may include a second voltage change detection circuit that employs a comparator. Specifically, the circuit structure of the second voltage change detection circuit may be the same as the circuit structure of the first voltage change detection circuit 511, and includes a second comparator, where a non-inverting input end of the second comparator is connected to the second pin, an inverting input end of the second comparator is connected to one end of a seventh resistor and one end of an eighth resistor, the other end of the seventh resistor is connected to a power supply, the other end of the eighth resistor is connected to the ground, and an output end of the second comparator is connected to the input end of the second switch circuit.

In the embodiment of the present invention, a first detecting module is connected onto a connector of a first rack, and a second detecting module is connected onto a corresponding connector of a second rack, where the first rack is connected to the second rack through a parallel cable; a first resistor in the first detecting module is connected in series between the first pin and a power supply, and a second resistor in the second detecting module is connected in series between the second pin and the ground, and therefore, when the parallel cable is faulty, both the voltage of the first pin and the voltage of the second pin change. Afterward, the first detecting module controls change of the level state of the first fault detection point according to the voltage change of the first pin, and the second detecting module controls change of the level state of the second fault detection point according to the voltage change of the second pin. In this way, when a parallel cable is faulty, both the level state of the first fault detection point and the level state of the second fault detection point change, and it can be quickly detected that the parallel cable between the two fault detection points is faulty; the problem in the prior art that only one rack raises an alarm and the faulty parallel cable cannot be located quickly is solved; and an operator can rectify a fault quickly and recover normal running of the system of combined racks in time. Moreover, because both fault detection points can detect the fault, false alarms possibly arising from the alarm of a single rack are prevented.

### Embodiment 6

Further, the embodiment of the present invention provides a system for detecting faults on a parallel cable. The system includes a first rack, a second rack, a parallel cable, and an apparatus for detecting faults on a parallel cable, the parallel cable is used to transmit data between the first rack and the second rack, one end of the parallel cable is connected to a first connector of the first rack, the other end of the parallel cable is connected to a second connector of the second rack, the first connector includes multiple first pins, and the second connector includes multiple second pins; the apparatus for detecting faults on a parallel cable is set at both ends of the parallel cable, and may be any one of the apparatuses for detecting faults on a parallel cable that are disclosed in Embodiments 1 to 5.

Specifically, the racks may be devices that need to interact with each other through interconnection, for example, a UPS, a frequency converter, or a telecom cabinet. The first detecting module of the apparatus for detecting faults on a parallel cable is connected to one end of the parallel cable, and the second detecting module of the apparatus for detecting faults on a parallel cable is connected to the other end of the parallel cable.

In the embodiment of the present invention, a first detecting module is connected onto a connector of a first rack, and a second detecting module is connected onto a corresponding connector of a second rack, where the first rack is connected to the second rack through a parallel cable; a first resistor in the first detecting module is connected in series between the first pin and a power supply, and a second resistor in the second detecting module is connected in series between the second pin and the ground, and therefore, when the parallel cable is faulty, both the voltage of the first pin and the voltage of the second pin change. Afterward, the first detecting module controls change of the level state of the first fault detection point according to the voltage change of the first pin, and the second detecting module controls change of the level state of the second fault detection point according to the voltage change of the second pin. In this way, when a parallel cable is faulty, both the level state of the first fault detection point and the level state of the second fault detection point change, and it can be quickly detected that the parallel cable between the two fault detection points is faulty; the problem in the prior art that only one rack raises an alarm and the faulty parallel cable cannot be located quickly is solved; and an operator can eliminate a fault quickly and recover normal running of the system of combined racks in time. Moreover, because both fault detection points can detect the fault, false alarms possibly arising from the alarm of a single rack are prevented. Besides, because a stand-alone control module is applied, when multiple racks run in parallel, one host device may monitor all parallel cables simultaneously, with easy control and high efficiency.

Persons of ordinary skill in the art may understand that all or a part of the steps of the foregoing embodiments may be implemented through hardware, or may be implemented by a program instructing relevant hardware. The program may be stored in a computer readable storage medium. The storage medium may be a read-only memory, a magnetic disk, or an optical disk.

The foregoing description is merely about exemplary embodiments of the present invention, but is not intended to limit the present invention which is limited only by the claims.

## Claims

1. An apparatus for detecting faults on a parallel cable, wherein the parallel cable is used to transmit data between a first rack and a second rack, one end of the parallel cable is connected to a first connector of the first rack, the other end of the parallel cable is connected to a second connector of the second rack, the first connector comprises multiple first pins, and the second connector comprises multiple second pins, **characterized in that**,
the apparatus comprises a first detecting module (11), a second detecting module (12), and a control module (13);
the first detecting module comprises a first resistor (R1), a first voltage change detection circuit (111), and a first switch circuit (112), wherein the first resistor is connected in series between one of the first pins (11a, 21 a) and a power supply (VCC), the first voltage change detection circuit is configured to output a first switch control signal according to voltage change of the first pin (11a, 21a), an input end of the first voltage change detection circuit (111) is connected to the first pin (11a, 21a), an output end of the first voltage change detection circuit (111) is connected to an input end of the first switch circuit (112), a first fault detection point (11b) is set on an output end of the first switch circuit (112), and the first switch circuit is configured to control a level state of the first fault detection point (11b) according to the first switch control signal output by the first voltage change detection circuit (111);
the second detecting module (12) comprises a second resistor (R2) and a second fault detection point (12b), the second resistor (R2) is connected in series between one of the second pins (12a) and the ground, and the second fault detection point (12b) is set between the second pin (12a) and a non-grounded end of the second resistor (R2); and
the control module (13) is configured to send out an alarm signal when a level state of the first fault detection point (11b) and a level state of the second fault detection point (12b) change.

2. The apparatus according to claim 1, wherein:
the first voltage change detection circuit comprises a first zener diode (ZD1), a cathode of the first zener diode is connected to the first pin (21 a), and an anode of the first zener diode (211) is connected to the input end of the first switch circuit.

3. The apparatus according to claim 1, wherein:
the first voltage change detection circuit comprises a first comparator (U1), a third resistor (R3), and a fourth resistor (R4), wherein a non-inverting input end of the first comparator is connected to the first pin (21a), an inverting input end of the first comparator is connected to one end of the third resistor (R3) and one end of the fourth resistor (R4), the other end of the third resistor is connected to the power supply, the other end of the fourth resistor is connected to the ground, and an output end of the first comparator is connected to the input end of the first switch circuit.

4. The apparatus according to claim 1, wherein:
the first switch circuit comprises a first triode (Q1) and a fifth resistor (R5), a base electrode of the first triode is connected to an output end of the first voltage change detection circuit, an collector of the first triode is connected to the power supply through the fifth resistor, an emitter of the first triode is connected to the ground, and the first fault detection point is set on the collector of the first triode.

5. The apparatus according to claim 1, wherein:
the second detecting module further comprises a second switch circuit, wherein the second switch circuit is configured to control the level state of the second fault detection point according to voltage change of the second pin, an input end of the second switch circuit is connected to the second pin, and an output end of the second switch circuit is connected to the second fault detection point.

6. The apparatus according to claim 5, wherein:
the second switch circuit comprises a second triode (Q2) and a sixth resistor (R6), a base electrode of the second triode is connected to the second pin (22a), an collector of the second triode is connected to the power supply through the sixth resistor (R6), an emitter of the second triode is connected to the ground, and the collector of the second triode is connected to the second fault detection point (32b).

7. The apparatus according to claim 5, wherein:
the second detecting module further comprises a second voltage change detection circuit that is configured to output a second switch control signal according to voltage change of the second pin, wherein the second switch circuit controls the level state of the second fault detection point according to the second switch control signal output by the second voltage change detection circuit, the input end of the second voltage change detection circuit is connected to the second pin, and the output end of the second voltage change detection circuit is connected to the input end of the second switch circuit.

8. The apparatus according to claim 7, wherein:
the second voltage change detection circuit comprises a second zener diode (ZD2), a cathode of the second zener diode (ZD2) is connected to the second pin (22a), and an anode of the second zener diode is connected to the input end of the second switch circuit.

9. The apparatus according to claim 7, wherein:
the second voltage change detection circuit comprises a second comparator, a seventh resistor, and an eighth resistor, wherein a non-inverting input end of the second comparator is connected to the second pin, an inverting input end of the second comparator is connected to one end of the seventh resistor and one end of the eighth resistor, the other end of the seventh resistor is connected to the power supply, the other end of the eighth resistor is connected to the ground, and an output end of the second comparator is connected to the input end of the second switch circuit.

10. A system for detecting faults on a parallel cable, comprising a first rack, a second rack, a parallel cable, and an apparatus for detecting faults on a parallel cable according to any one of claims 1 to 9, wherein: the parallel cable is used to transmit data between the first rack and the second rack, one end of the parallel cable is connected to a first connector of the first rack, the other end of the parallel cable is connected to a second connector of the second rack, the first connector comprises multiple first pins, and the second connector comprises multiple second pins.

## Patentansprüche

1. Vorrichtung zum Detektieren von Fehlern auf einem Parallelkabel, wobei das Parallelkabel verwendet wird, um Daten zwischen einem ersten Gestellrahmen und einem zweiten Gestellrahmen zu übertragen, ein Ende des Parallelkabels mit einem ersten Verbindungselement des ersten Gestellrahmens verbunden ist, das andere Ende des Parallelkabels mit einem zweiten Verbindungselement des zweiten Gestellrahmens verbunden ist, das erste Verbindungselement mehrere erste Anschlussstifte umfasst und das zweite Verbindungselement mehrere zweite Anschlussstifte umfasst, **dadurch gekennzeichnet, dass**
die Vorrichtung ein erstes Detektionsmodul (11), ein zweites Detektionsmodul (12) und ein Steuermodul (13) umfasst;
das erste Detektionsmodul einen ersten Widerstand (R1), einen ersten Spannungsänderungsdetektionsschaltkreis (111) und einen ersten Schaltungsschaltkreis (112) umfasst, wobei der erste Widerstand in Reihe zwischen einen der ersten Anschlussstifte (11a, 21a) und eine Stromversorgung (VCC) geschaltet ist, der erste Spannungsänderungsdetektionsschaltkreis konfiguriert ist, ein erstes Schaltungssteuersignal gemäß der Spannungsänderung des ersten Anschlussstifts (11a, 21 a) auszugeben, ein Eingangsende des ersten Spannungsänderungsdetektionsschaltkreises (111) mit dem ersten Anschlussstift (11a, 21 a) verbunden ist, ein Ausgangsende des ersten Spannungsänderungsdetektionsschaltkreises (111) mit einem Eingangsende des ersten Schaltungsschaltkreises (112) verbunden ist, ein erster Fehlerdetektionspunkt (11b) auf ein Ausgangsende des ersten Schaltungsschaltkreises (112) gesetzt ist und der erste Schaltungsschaltkreis konfiguriert ist, einen Pegelzustand des ersten Fehlerdetektionspunkts (11b) gemäß dem ersten Schaltungssteuersignal, das durch den ersten Spannungsänderungsdetektionsschaltkreis (111) ausgegeben wird, zu steuern;
das zweite Detektionsmodul (12) einen zweiten Widerstand (R2) und einen zweiten Fehlerdetektionspunkt (12b) umfasst, wobei der zweite Widerstand (R2) in Reihe zwischen einen der zweiten Anschlussstifte (12a) und Erde geschaltet ist und der zweite Fehlerdetektionspunkt (12b) zwischen dem zweiten Anschlussstift (12a) und einem nicht geerdeten Ende des zweiten Widerstands (R2) gesetzt ist; und
das Steuermodul (13) konfiguriert ist, ein Alarmsignal auszusenden, wenn sich ein Pegelzustand des ersten Fehlerdetektionspunkts (11b) und ein Pegelzustand des zweiten Fehlerdetektionspunkts (12b) ändert.

2. Vorrichtung nach Anspruch 1, wobei:
der erste Spannungsänderungsdetektionsschaltkreis eine erste Zenerdiode (ZD1) umfasst, wobei eine Kathode der ersten Zenerdiode mit dem ersten Anschlussstift (21a) verbunden ist und eine Anode der ersten Zenerdiode (211) mit dem Eingangsende des ersten Schaltungsschaltkreises verbunden ist.

3. Vorrichtung nach Anspruch 1, wobei:
der erste Spannungsänderungsdetektionsschaltkreis einen ersten Komparator (U1),
einen dritten Widerstand (R3) und einen vierten Widerstand (R4) umfasst, wobei ein nichtinvertierendes Eingangsende des ersten Komparators mit dem ersten Anschlussstift (21a) verbunden ist, ein invertierendes Eingangsende des ersten Komparators mit einem Ende des dritten Widerstands (R3) und einem Ende des vierten Widerstands (R4) verbunden ist, das andere Ende des dritten Widerstands mit der Stromversorgung verbunden ist, das andere Ende des vierten Widerstands mit Erde verbunden ist und ein Ausgangsende des ersten Komparators mit dem Eingangsende des ersten Schaltungsschaltkreises verbunden ist.

4. Vorrichtung nach Anspruch 1, wobei:
der erste Schaltungsschaltkreis eine erste Triode (Q1) und einen fünften Widerstand (R5) umfasst, wobei eine Basiselektrode der ersten Triode mit einem Ausgangsende des ersten Spannungsänderungsdetektionsschaltkreises verbunden ist, ein Kollektor der ersten Triode mit der Stromversorgung über den fünften Widerstand verbunden ist, ein Emitter der ersten Triode mit Erde verbunden ist und der erste Fehlerdetektionspunkt auf den Kollektor der ersten Triode gesetzt ist.

5. Vorrichtung nach Anspruch 1, wobei:
das zweite Detektionsmodul ferner einen zweiten Schaltungsschaltkreis umfasst,
wobei der zweite Schaltungsschaltkreis konfiguriert ist, den Pegelzustand des zweiten Fehlerdetektionspunkts gemäß der Spannungsänderung des zweiten Anschlussstifts zu steuern, ein Eingangsende des zweiten Schaltungsschaltkreises mit dem zweiten Anschlussstift verbunden ist und ein Ausgangsende des zweiten Schaltungsschaltkreises mit dem zweiten Fehlerdetektionspunkt verbunden ist.

6. Vorrichtung nach Anspruch 5, wobei:
der zweite Schaltungsschaltkreis eine zweite Triode (Q2) und einen sechsten Widerstand (R6) umfasst, wobei eine Basiselektrode der zweiten Triode mit dem zweiten Anschlussstift (22a) verbunden ist, ein Kollektor der zweiten Triode mit der Stromversorgung über den sechsten Widerstand (R6) verbunden ist, ein Emitter der zweiten Triode mit Erde verbunden ist und ein Kollektor der zweiten Triode mit dem zweiten Fehlerdetektionspunkt (32b) verbunden ist.

7. Vorrichtung nach Anspruch 5, wobei:
das zweite Detektionsmodul ferner einen zweiten Spannungsänderungsdetektionsschaltkreis umfasst, der konfiguriert ist, ein zweites Schaltungssteuersignal gemäß der Spannungsänderung des zweiten Anschlussstifts auszugeben, wobei der zweite Schaltungsschaltkreis den Pegelzustand des zweiten Fehlerdetektionspunkts gemäß dem durch das zweite Spannungsänderungsdetektionsschaltkreis ausgegebenen Schaltungssteuersignal steuert, das Eingangsende des zweiten Spannungsänderungsdetektionsschaltkreises mit dem zweiten Anschlussstift verbunden ist und das Ausgangsende des zweiten Spannungsänderungsdetektionsschaltkreises mit dem Eingangsende des zweiten Schaltungsschaltkreises verbunden ist.

8. Vorrichtung nach Anspruch 7, wobei:
der zweite Spannungsänderungsdetektionsschaltkreis eine zweite Zenerdiode (ZD2) umfasst, wobei eine Kathode der zweiten Zenerdiode (ZD2) mit dem zweiten Anschlussstift (22a) verbunden ist und eine Anode der zweiten Zenerdiode mit dem Eingangsende des zweiten Schaltungsschaltkreises verbunden ist.

9. Vorrichtung nach Anspruch 7, wobei:
der zweite Spannungsänderungsdetektionsschaltkreis einen zweiten Komparator,
einen siebten Widerstand und einen achten Widerstand umfasst, wobei ein nichtinvertierendes Eingangsende des zweiten Komparators mit dem zweiten Anschlussstift verbunden ist, ein invertierendes Eingangsende des zweiten Komparators mit einem Ende des siebten Widerstands und einem Ende des achten Widerstands verbunden ist, das andere Ende des siebten Widerstands mit der Stromversorgung verbunden ist, das andere Ende des achten Widerstands mit Erde verbunden ist und ein Ausgangsende des zweiten Komparators mit dem Eingangsende des zweiten Schaltungsschaltkreises verbunden ist.

10. System zum Detektieren von Fehlern auf einem Parallelkabel, das einen ersten Gestellrahmen, einen zweiten Gestellrahmen, ein Parallelkabel und eine Vorrichtung zum Detektieren von Fehlern auf einem Parallelkabel nach einem der Ansprüche 1 bis 9 umfasst, wobei: das Parallelkabel verwendet wird, um Daten zwischen dem ersten Gestellrahmen und dem zweiten Gestellrahmen zu übertragen, ein Ende des Parallelkabels mit einem ersten Verbindungselement des ersten Gestellrahmens verbunden ist, das andere Ende des Parallelkabels mit einem zweiten Verbindungselement des zweiten Gestellrahmens verbunden ist, das erste Verbindungselement mehrere erste Anschlussstifte umfasst und das zweite Verbindungselement mehrere zweite Anschlussstifte umfasst.

## Revendications

1. Appareil pour détecter des défauts sur un câble parallèle, le câble parallèle servant à transmettre des données entre une première baie et une deuxième baie, une extrémité du câble parallèle étant reliée à un premier connecteur de la première baie, l'autre extrémité du câble parallèle étant reliée à un deuxième connecteur de la deuxième baie, le premier connecteur comprenant plusieurs premières broches et le deuxième connecteur comprenant plusieurs deuxièmes broches, **caractérisé en ce que** :
l'appareil comprend un premier module de détection (11), un deuxième module de détection (12) et un module de commande (13) ;
le premier module de détection comprend une première résistance (R1), un premier circuit de détection de changement de tension (111) et un premier circuit de commutation (112), la première résistance étant montée en série entre une des premières broches (11a, 21a) et une alimentation (VCC), le premier circuit de détection de changement de tension étant configuré pour fournir un premier signal de commande de commutation en fonction d'un changement de tension de la première broche (11a, 21a), une extrémité d'entrée du premier circuit de détection de changement de tension (111) étant reliée à la première broche (11a, 21a), une extrémité de sortie du premier circuit de détection de changement de tension (111) étant reliée à une extrémité d'entrée du premier circuit de commutation (112), un premier point de détection de défaut (11b) étant établi sur une extrémité de sortie du premier circuit de commutation (112) et le premier circuit de commutation étant configuré pour commander un état de niveau du premier point de détection de défaut (11b) en fonction du premier signal de commande de commutation fourni par le premier circuit de détection de changement de tension (111) ;
le deuxième module de détection (12) comprend une deuxième résistance (R2) et un deuxième point de détection de défaut (12b), la deuxième résistance (R2) étant montée en série entre une des deuxièmes broches (12a) et la masse, et le deuxième point de détection de défaut (12b) étant établi entre la deuxième broche (12a) et une extrémité non mise à la masse de la deuxième résistance (R2) ; et
le module de commande (13) est configuré pour envoyer un signal d'alarme en cas de changement d'un état de niveau du premier point de détection de défaut (11b) et d'un état de niveau du deuxième point de détection de défaut (12b).

2. Appareil selon la revendication 1, dans lequel :
le premier circuit de détection de changement de tension comprend une première diode Zener (ZD1), une cathode de la première diode Zener étant reliée à la première broche (21a) et une anode de la première diode Zener (211) étant reliée à l'extrémité d'entrée du premier circuit de commutation.

3. Appareil selon la revendication 1, dans lequel :
le premier circuit de détection de changement de tension comprend un premier comparateur (U1), une troisième résistance (R3) et une quatrième résistance (R4),
une extrémité d'entrée non inverseuse du premier comparateur étant reliée à la première broche (21a), une extrémité d'entrée inverseuse du premier comparateur étant reliée à une extrémité de la troisième résistance (R3) et une extrémité de la quatrième résistance (R4), l'autre extrémité de la troisième résistance étant reliée à l'alimentation, l'autre extrémité de la quatrième résistance étant reliée à la masse et
une extrémité de sortie du premier comparateur étant reliée à l'extrémité d'entrée du premier circuit de commutation.

4. Appareil selon la revendication 1, dans lequel :
le premier circuit de commutation comprend une première triode (Q1) et une cinquième résistance (R5), une électrode de base de la première triode étant reliée à une extrémité de sortie du premier circuit de détection de changement de tension, un collecteur de la première triode étant relié à l'alimentation via la cinquième résistance, un émetteur de la première triode étant relié à la masse et le premier point de détection de défaut étant établi sur le collecteur de la première triode.

5. Appareil selon la revendication 1, dans lequel :
le deuxième module de détection comprend en outre un deuxième circuit de commutation, le deuxième circuit de commutation étant configuré pour commander l'état de niveau du deuxième point de détection de défaut en fonction d'un changement de tension de la deuxième broche, une extrémité d'entrée du deuxième circuit de commutation étant reliée à la deuxième broche et une extrémité de sortie du deuxième circuit de commutation étant reliée au deuxième point de détection de défaut.

6. Appareil selon la revendication 5, dans lequel :
le deuxième circuit de commutation comprend une deuxième triode (Q2) et une sixième résistance (R6), une électrode de base de la deuxième triode étant reliée à la deuxième broche (22a), un collecteur de la deuxième triode étant relié à l'alimentation via la sixième résistance (R6), un émetteur de la deuxième triode étant relié à la masse et le collecteur de la deuxième triode étant relié au deuxième point de détection de défaut (32b).

7. Appareil selon la revendication 5, dans lequel :
le deuxième module de détection comprend en outre un deuxième circuit de détection de changement de tension configuré pour fournir un deuxième signal de commande de commutation en fonction d'un changement de tension de la deuxième broche, le deuxième circuit de commutation commandant l'état de niveau du deuxième point de détection de défaut en fonction du deuxième signal de commande de commutation fourni par le deuxième circuit de détection de changement de tension, l'extrémité d'entrée du deuxième circuit de détection de changement de tension étant reliée à la deuxième broche et l'extrémité de sortie du deuxième circuit de détection de changement de tension étant reliée à l'extrémité d'entrée du deuxième circuit de commutation.

8. Appareil selon la revendication 7, dans lequel :
le deuxième circuit de détection de changement de tension comprend une deuxième diode Zener (ZD2), une cathode de la deuxième diode Zener (ZD2) étant reliée à la deuxième broche (22a) et une anode de la deuxième diode Zener étant reliée à l'extrémité d'entrée du deuxième circuit de commutation.

9. Appareil selon la revendication 7, dans lequel :
le deuxième circuit de détection de changement de tension comprend un deuxième comparateur, une septième résistance et une huitième résistance, une extrémité d'entrée non inverseuse du deuxième comparateur étant reliée à la deuxième broche,
une extrémité d'entrée inverseuse du deuxième comparateur étant reliée à une extrémité de la septième résistance et une extrémité de la huitième résistance, l'autre extrémité de la septième résistance étant reliée à l'alimentation, l'autre extrémité de la huitième résistance étant reliée à la masse et une extrémité de sortie du deuxième comparateur étant reliée à l'extrémité d'entrée du deuxième circuit de commutation.

10. Système pour détecter des défauts sur un câble parallèle, comprenant une première baie, une deuxième baie, un câble parallèle et un appareil pour détecter des défauts sur un câble parallèle selon l'une quelconque des revendications 1 à 9, dans lequel :
le câble parallèle sert à transmettre des données entre la première baie et la deuxième baie, une extrémité du câble parallèle est reliée à un premier connecteur de la première baie, l'autre extrémité du câble parallèle est reliée à un deuxième connecteur de la deuxième baie, le premier connecteur comprend plusieurs premières broches et le deuxième connecteur comprend plusieurs deuxièmes broches.
